# EUROPEAN PATENT APPLICATION

(11) **EP 1 870 722 A1**
(43) Date of publication of application: **26.12.2007**
(21) Application number: 07011992.0
(22) Date of filing: 19.06.2007
(51) Int. Cl.: G01R 31/311

(54) **System and method for thermal management and gradient reduction**

(30) Priority: 19.06.2006 US 455996
(71) Applicant: CREDENCE SYSTEMS CORPORATION, Milpitas, CA 95035 (US)
(72) Inventor: Lee, Birk, Atherton CA 94025 (US)
(74) Representative: Leidescher, Thomas

(57) **Abstract**

A micro-spray cooling system beneficial for use in testers of electrically stimulated integrated circuit chips is disclosed. The system includes micro-spray heads disposed about a probe head, which provide a coolant flow onto the IC (160; 360). A flow inducing injector (190; 362; 462; 562; 862) is provided that directs a fluid jet onto zones where stagnation of the coolant flow is present. This reduces or eliminates any stagnation points and enhance temperature uniformity over the area of the IC.

## Description

The present invention relates to ICs. In particular, the present invention relates to a system and a method for thermal management of an electrically stimulated semiconductor integrated circuit undergoing probing, diagnostics, or failure analysis. Specifically, it relates to a method for controlling operating temperature of an IC undergoing testing, an apparatus for controlling the temperature of an IC undergoing testing, and a method for testing of an IC

Integrated circuits (ICs) are being used in increasing numbers of consumer devices, apart from the well-known personal computer itself. Examples include automobiles, communication devices, and smart homes (dishwashers, furnaces, refrigerators, etc.). This widespread adoption has also resulted in ever larger numbers of ICs being manufactured each year. With increased IC production comes the possibility of increased IC failure, as well as the need for fast and accurate chip probing, debug, and failure analysis technologies. The primary purpose of today's probing, debug, and failure analysis systems is to characterize the gate-level performance of the chip under evaluation, and to identify the location and cause of any operational faults.

In the past, mechanical probes were used to quantify the electrical switching activity. Due to the extremely high circuit densities, speeds, and complexities of today's chips, including the use of flip-chip technology, it is now physically impossible to probe the chips mechanically without destructively disassembling them. Thus, it is now necessary to use non-invasive probing techniques for chip diagnostics. Such techniques involve, for example, laser-based approaches to measure the electric fields in silicon, or optically-based techniques that detect weak light pulses that are emitted from switching devices, e.g., field-effect transistors (FETs), during switching. Examples of typical microscopes for such investigations are described in, for example, USP 4,680,635; 4,811,090; 5,475,316; 5,940,545 and Analysis of Product Hot Electron Problems by Gated Emission Microscope, Khurana et al., IEEE/IRPS (1986), which are incorporated herein by reference.

During chip testing, the chip is typically exercised at relatively high speeds by a tester or other stimulating circuit. Such activity results in considerable heat generation. When the device is encapsulated and is operated in its normal environment, various mechanisms are provided to assist in heat dissipation. For example, metallic fins are often attached to the IC, and cooling fans are provided to enhance air flow over the IC. However, when the device is under test, the device is not encapsulated and, typically, its substrate is thinned down for testing purposes. Consequently, no means for heat dissipation are available and the device under test (DUT) may operate under excessive heat so as to distort the tests, and may ultimately fail prematurely. Therefore, there is a need for effective thermal management of the DUT.

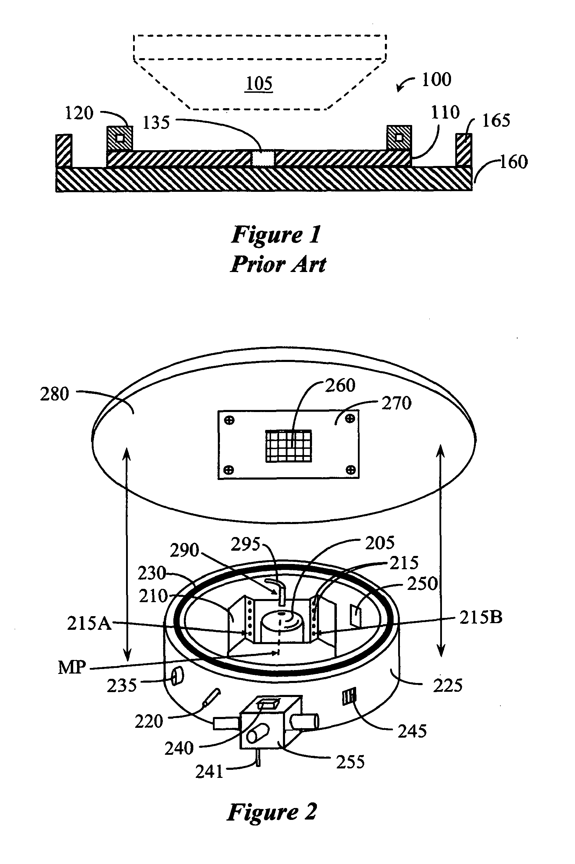

One prior art system used to cool the DUT is depicted in Figure 1. The cooling device 100 consists of a cooling plate 110 having a window 135 to enable optical probing of the DUT. The window 135 may be a simple cut out, or may be made of thermally conductive transparent material, such as synthetic diamond. The use of synthetic diamond to enhance cooling is described in, for example, USP 5,070,040, which is incorporated herein by reference. Conduits 120 are affixed to the cooling plate 110 for circulation of cooling liquid. Alternatively, the conduits may be formed as an integral part of the plate.

Figure 1 depicts in broken line a microscope objective 105 used for the optical inspection, and situated in alignment with the window 135. During testing, the cooling plate is placed on the exposed surface of the DUT 160, with the window 135 placed over the location of interest. Heat from the device is conducted by the cooling plate to the conduits and the cooling liquid. The cooling liquid is then made to circulate through a liquid temperature conditioning system, such as a chiller, thereby removing the heat from the device. Typically, however, the DUT includes auxiliary devices 165, which limit the available motion of the cooling plate, thereby limiting the area available for probing To overcome this, custom plates are made for specific devices, leading to increased cost and complexity of operation of the tester.

There is a need for an innovative, inexpensive, flexible, and thermally effective thermal management solution for chip testers or probers.
In light of the above, a method for controlling operating temperature of an IC undergoing testing according to independent claim 1, an apparatus for controlling temperature of an IC undergoing testing according to independent claim 5 and a method for testing of an IC according to independent claim 156 are provided.
Further advantages, features, aspects and details of the invention are evident from the dependent claims, the description and the drawings.

The present invention provides a mechanism for removing heat from a DUT, thereby allowing for inspection of the device under electrical stimulation. Therefore, the system is particularly adaptable for use with optical microscopes used for probing, diagnostics and failure analysis of the DUT.

In one aspect of the invention, a thermal management system is provided which utilizes an atomized liquid spray for controlling the temperature of the DUT, such as by acting as a heat sink or heat source. A spray head is provided about an objective lens housing, and this arrangement is placed inside a spray chamber. The spray chamber is coupled to a plate upon which the DUT is situated. The pressure inside the chamber may be controlled to obtain the proper evaporation of the sprayed liquid. Pressure transducers and temperature sensors may be installed on the pressure chamber to monitor the operation of the thermal management system. A flow inducing injector is provided to reduce or prevent stagnation points over the DUT.

In another aspect of the invention, the spray of the fluid is accomplished using several banks of atomizers or nozzles which provide fine spray, fine mist, etc. According to one implementation, all of the atomizers are commonly connected to one liquid supply. On the other hand, according to other implementations, liquid delivery to each, or to groups, of atomizers may be controlled separately so as to vary the pressure, the timing, and/or the type of liquid delivered to various atomizers. A flow inducing injector is provided to induce flow at the intersection of the atomizers' stream, so as to prevent stagnation at the intersection.

In a further aspect of the invention, control instrumentation is provided for accurate operation of the thermal management system. The DUT temperature can be controlled via the sprayed fluid's temperature, flow rate (directly tied to fluid delivery pressure), spray pattern and density, and fluid boiling point (a function of spray chamber pressure and vapor temperature). Note that at its saturation temperature, the temperature of the saturation liquid is the same as its vapor (non-superheated). An optional temperature sensor close to the fluid delivery point monitors the fluid delivery temperature, which is fed back to the thermal management system's controller. The controller controls the fluid temperature conditioning system, which may be a chiller or other device to control the fluid's temperature to a pre-determined value. The operation of the flow inducing injector is controlled to effectively avoid temperature gradient on the DUT at potential stagnation points. The control can be done by varying, e.g., the pressure or temperature of the fluid of the flow inducing injector.

Spray chamber pressure is optionally measured with a pressure transducer in communication with the spray chamber. Vapor temperature (measured with a temperature sensor in communication with the spray chamber) and spray chamber pressure determine the fluid's boiling point, which in turn influences the manner in which the DUT temperature is controlled. The spray chamber pressure can be manipulated to influence the fluid's boiling point. The spray chamber pressure may be affected, for example, by a solenoid valve in communication with the spray chamber, by adjusting the return pump's speed, or by manipulating the pressure inside the liquid temperature conditioning system's reservoir. An optional mechanical pressure relief valve provides a safety release in the event that the solenoid valve fails.

One or more of the afore-mentioned approaches, individually or in combination, may be used to control the fluid flow rate and/or the fluid's boiling point. The ultimate goal is to use the instrumentation to control the DUT to a pre-determined temperature. The temperature of the DUT may be measured by mechanical contact with a thermocouple or other sensor, by noncontact means such as a thermal imaging camera, or by any other means suitably accurate for the intended temperature stability. Any means for measuring the DUT temperature may be employed in the control of the DUT temperature. The specific examples given here are meant for illustrative purposes only and are not meant to limit this invention in any way.

A computer or other electronic or mechanical control system may be used to monitor DUT temperature and provide the necessary adjustment of spray. For example, if the DUT temperature rises, the computer could increase the flow rate, decrease the fluid temperature, or both. Similarly, if a temperature gradient is developed at a stagnation point, the flow inducing injector can be controlled to reduce or eliminate such a gradient by inducing flow at the stagnation point.

In a further aspect of the invention, a solid immersion lens (SIL) is used in combination with the objective lens. SILs are well known to those skilled in the art and are included here by reference. The SIL enables transmission of optical energy between the DUT and the objective lens regardless of the type and manner of cooling spray used. Thus, the atomizers and the fluid pressure can be selected freely for optimal heat removal efficiency. For example, the size, design/style, density, angle, and number of atomizers can all be adjusted. In addition, the temperature and type of coolant used can also be adjusted. The flow inducing injector can be aimed at or near the SIL contact point so as to prevent stagnation about the SIL.

In yet a further aspect of the invention, several flow inducing injectors are provided, which can be operated simultaneously or individually to reduce stagnation at various locations. In other embodiments the flow inducing injector is movable and can be placed at different locations as needed.
Embodiments are also directed to apparatuses for carrying out the disclosed methods and including apparatus parts for performing described method steps. Furthermore, embodiments according to the invention are also directed to methods by which the described apparatus operates or by which the described apparatus is manufactured. It may include method steps for carrying out functions of the apparatus or manufacturing parts of the apparatus. The method steps may be performed by way of hardware components, firmware, a computer programmed by appropriate software, by any combination thereof or in any other manner.

The invention is described herein with reference to particular embodiments thereof which are exemplified in the drawings. It should be understood, however, that the various embodiments depicted in the drawings are only exemplary and may not limit the invention as defined in the appended claims.

Figure 1 depicts a plate cooling system according to the prior art.

Figure 2 depicts an embodiment of the inventive cooling system in an exploded view.

Figure 3 depicts a cross section schematic of an embodiment of the inventive cooling system.

Figure 4 depicts an embodiment of the inventive cooling system using a solid immersion lens.

Figure 5 is a top view of an embodiment of the invention.

Figure 6 is a schematic of a DUT showing locations of temperature sensor used in testing an embodiment of the invention.

Figure 7 is a plot showing the temperatures registered by the sensors shown in Figure 6.

Figure 8 depicts an embodiment that is similar to that of Figure 5, except that the flow direction is directed from the SIL contact area and outwards.

Various embodiments and implementations of the present invention can be used in conjunction with various IC testers and probers, so as to provide cooling of an IC that is electrically stimulated. In one general aspect, an atomized liquid spray is provided about a probe head so as to cool the DUT as the probe head collects data. Any probe head may be used, for example, the probe head may be in the form of an optical photon-counting time-resolved receiver, optical emission microscope, or laser-based probing tool. In order to provide a more detailed explanation of various aspects and features of the invention, the invention will be described with reference to more specific IC probers, i.e., optical photon-counting time-resolved emission probers. However, it should be appreciated that such detailed description is provided only as an example and not by way of limitation.

Figure 2 depicts an exploded view of one embodiment of the inventive cooling system. The cooling system depicted in Figure 2 may be used with any type of microscope used for inspection and/or testing of ICs. For clarity, Figure 2 shows only the objective lens portion of the optical inspection/probing system, and the parts relating to its cooling system. As shown in Figure 2, a retention frame 270 holds the DUT 260 onto seal plate 280. The seal plate is mounted to a load board, which in turn is connected to a conventional test head (not shown) of a conventional automated testing equipment (ATE). The ATE sends stimulating signals to the DUT 260, to simulate operating conditions of the DUT 260. This is done conventionally using the load board with an appropriate socket for the DUT.

An objective housing 205 houses the objective lens of the testing system. The housing 205 and objective lens generally form an optical receiver of the system, i.e., the probe head. The housing 205 is mounted along with a spray head 210 having atomizers 215 provided therein. This entire assembly is situated inside spray chamber 225, having an optional seal 230 affixed to its upper surface. The seal 230 may be made or rubber, such as an o-ring, or of porous material, or otherwise. For an ease of operation of the prober, it is beneficial to design the seal so that it allows free sliding of the cooling chamber with respect to the seal plate. The spray chamber 225 is affixed to a translation stage, e.g., an x-y-z stage (not shown). To perform testing in an embodiment employing the sliding seal, the spray chamber 225 is brought in contact with the sealing plate 280, so that sliding seal 230 creates a seal with the sealing plate 280. The seal may be hermetic, but a hermetic seal is not required. In this manner, the spray chamber 225 may be moved about so as to bring the objective lens into registration with the particular area of the DUT sought to be imaged, without breaking the seal with the sealing plate 280.

In another embodiment, the housing 225 is connected to the sealing plate 280 through a flexible bellows (not shown). The bellows material should be compatible with the fluid temperature and chemical properties. Some potential materials include folded thin-walled steel and rubber.

During testing, fluid is supplied to the atomizers 215 via fluid supply manifold 255. The boiling point of the fluid can be controlled by controlling the pressure inside the spray chamber 225 using solenoid 220, or otherwise. In one implementation of the invention, the pressure inside the spray chamber 225 is measured using pressure transducer 250 and of that of the fluid supply is measured using pressure transducer 240, while the temperature of the fluid is measured with temperature sensor 241 and of the spray is measured using temperature sensor 245. For fixed or varying fluid temperature and spray chamber pressure, the measured fluid delivery pressure is fed back to the controller to ensure adequate fluid delivery pressure for a required DUT temperature. The flow rate, and thus the temperature exchange rate, can be controlled by the fluid delivery pressure. As a safety measure, a mechanical pressure relief valve 235 is optionally provided.

Upon investigation of the operation of the system so far described, the inventor has determined that temperature gradients can be developed on the DUT 260 due to stagnation of fluid flow over the DUT. Stagnation points may be caused by, e.g., flows from two injectors hitting each other from opposite direction. For example, the flows from injectors 215A and 215B may collide at mid-point (illustrated by broken line MP) and cause a flow stagnation at that location. Such a flow stagnation can lead to temperature gradient on the DUT. To avoid such flow stagnation, a flow inducing injector 290 is provided inside the cooling chamber. The injector 290 is provided with fluid via conduit 295. By injecting fluid at a stagnation location, the injector 290 induces flow so as to reduce or avoid temperature gradient caused by flow stagnation. The temperature, pressure, pattern etc. of the fluid and injection can be controlled to achieve optimal results.

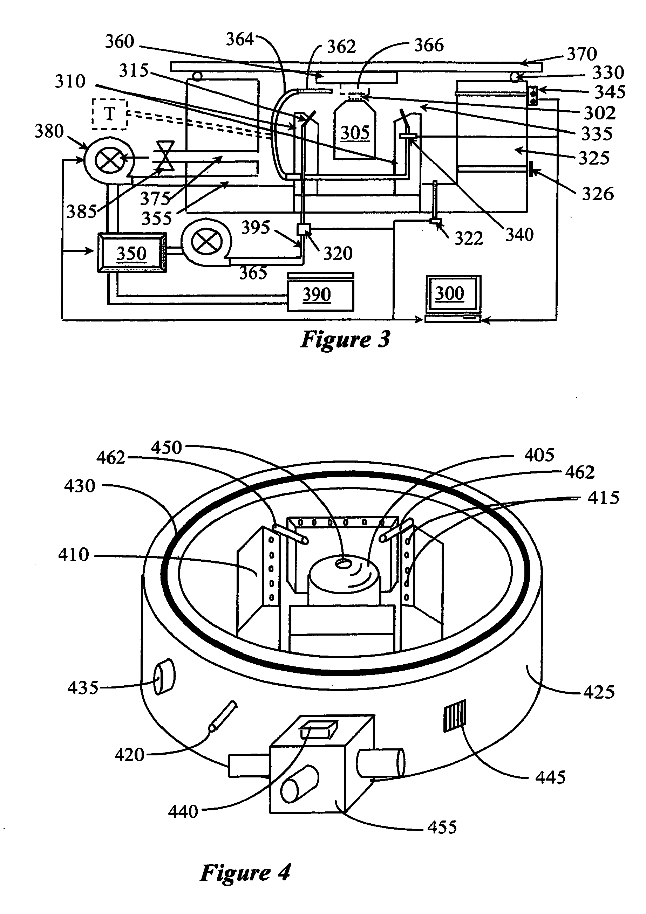

Figure 3 is a cross-sectional schematic of the spray cooling system according to an embodiment of the present invention. Specifically, DUT 360 is attached to seal plate 370, which is then mounted to the DUT load board (not shown). The load board is connected to a test adapter in a conventional manner. In this embodiment, spray chamber 325 is slightly pressed against the seal plate 370 so that sliding seal 330 contacts the seal plate 370. Objective housing 305 is located within the chamber 325, as are the spray heads 310. Pump 380 is used to return fluid to the liquid temperature conditioning system, such as a chiller 350, and can also be used to control the pressure inside the chamber interior 335, typically at about 1 atm. It should be understood that the desired spray chamber pressure can be calculated according to the characteristics of the cooling fluid used and the boiling point desired (in a given embodiment). Alternatively, the pressure inside the chamber can be atmospheric (especially when the seal 330 is porous), and fluid collection can be done by gravity alone.

Pump 365 is used to pump fluid through supply piping 395 to be injected onto the DUT via atomizer banks 315. In one embodiment of the invention, coolant is sprayed onto the stimulated DUT 360, whereupon the coolant is heated to its boiling point and then evaporates and vapor forms in the interior 335 of chamber 325. The vapor may then condense on the walls of chamber 325, and drained through channels 355, back into the pump 380 or via gravity back into the coolant system. The vapor may also be directly fed into the chiller 350, although the load on the chiller will be increased. In another embodiment, the coolant simply absorbs the heat from the DUT without evaporating, whereupon the unevaporated liquid is returned to the liquid temperature conditioning system. While two thermal management scenarios have been presented, those skilled in the art can appreciate the fact that the relative cooling strengths of the fluid heat absorption and the evaporation may be adjusted, for example, by choosing different fluids, nozzle design and number, fluid flow rate, fluid temperature, and chamber pressure as described above.

The fluid may then be circulated through the liquid temperature conditioning system 350 before being sprayed again onto the DUT. The coolant used in this embodiment is of high vapor pressure, e.g., hydrofluoroethers or perfluorocarbons, although fluids with low vapor pressure, e.g., water, can also be used. Consequently, such fluids evaporate readily when exposed to atmospheric condition. Therefore, as shown in this embodiment, the entire cooling system forms a closed loop system. The closed system may be vented through the solenoid valve 385, which may also be operated in conjunction with a vapor recovery system such as a reflux condenser to mitigate additional vapor loss. For this purpose, the liquid temperature conditioning system 350 comprises a sealed chiller reservoir 390, capable of operating at both high and low pressures, i.e., 10 psi above atmospheric pressure or a full vacuum of -1atm. The reservoir 390 may also include a fluid agitation system (not shown) to enhance heat transfer from the coolant to the chiller coils (not shown). In this example, the chiller 350 and reservoir 390 are capable of operating at low temperatures of down to, for example, -80°C.

Using this system, the temperature of the DUT can be varied so as to be tested under various operating conditions. For example, the operator may input a certain operating temperature for testing the DUT. In one embodiment, the actual temperature of the DUT can be detected by the ATE (not shown) in a manner known to those skilled in the art. For example, a temperature diode may be embedded in the DUT, and its signal sent to the ATE. This is conventionally done for safety reasons such as, for example, to shut the system if the DUT gets too hot. However, according to this embodiment of the invention, the temperature of the DUT is sent from the ATE to the controller 300. Using the actual DUT temperature, the controller 300 adjusts the temperature exchange rate, e.g., cooling rate, so as to operate the DUT at the temperature selected by the operator. To control the temperature exchange rate, the controller 300 may adjust, for example, the flow rate of fluid, the temperature of the fluid, or change the pressure in the chamber so as to change the boiling point of the cooling liquid.

As explained with respect to Figure 2, the spray from the various atomizers 315 may generate stagnation areas which may cause the DUT to heat locally, thereby creating unwanted temperature gradient in the DUT. To minimize or avoid such stagnation points, at least one flow inducing injector 362 is provided inside the chamber 325. The injector 362 is fed with cooling fluid via conduit 364, which may be connected to the conduit 395 as shown, or be fed separately with the same fluid or different fluid. The injector is directed at a flow stagnation areas so as to induce fluid flow. As can be understood, for illustration purposes the injector 362 is shown as directed from left to right; however, the stagnation area that would be created by atomizer banks 315 would generally be in the area marked by the broken-line rectangle 366.
Accordingly, an improved effect would be obtained by orienting the injector 362 in a manner so that its flow is directed at the broken-line rectangle area directed in-and-out of the page, i.e., towards or away from the reader.

Figure 3 depicts two possibilities for delivering fluid to the flow inducing injector. As is illustrated with the solid line pipe 364, the fluid can be delivered from the same fluid delivery system that delivers fluid to the atomizers 315. In this manner, the fluid temperature and pressure is controlled for both the atomizers 315 and flow inducing injector 362 concurrently. On the other hand, the broken line pipe coupled to broken-line rectangle T, illustrate the option to have a separate fluid delivery system to the flow-inducing injector. In this manner, the temperature and pressure of the fluid delivered to the inventor can be separately controlled.

As shown in Figures 2 and 3, and as alluded to above, various sensors and instrumentation may be used to control the operation of the inventive cooling system. A pressure transducer 320 measures the fluid delivery pressure so as to control the pump 365 speed. Additionally, a pressure transducer 322 measures the pressure inside the spray chamber so as to control a solenoid valve 385 to obtain the appropriate coolant boiling point inside the spray chamber. Temperature sensor 340 is used to measure the coolant temperature close to the point of delivery, while the vapor temperature in the spray chamber is measured with temperature sensor 345. Notably, from the spray chamber pressure and the vapor temperature (or coolant at its saturation temperature), it is possible to determine the thermodynamic state of the coolant delivered to the stimulated DUT. A mechanical pressure relief valve 326 provides a safety release in the event that the solenoid valve 385 fails.

In the embodiments of Figures 2 and 3, the effects of the atomized coolant on imaging needs to be minimized. One way to do this is by using the optional shield 302, so as to prevent the mist from entering the optical axis of the imaging system. In this manner, when the objective housing is moved in to image a particular area on the DUT, the shield can be made to touch, or to be very close, to the DUT so as to shield that area of the DUT from the mist. On the other hand, if one wishes to avoid the use of the shield, then the spray needs to be adjusted to enable best imaging under the wavelength of the light being used. That is, the droplet size of the mist needs to be controlled depending on the operation of the microscope. For example, imaging may be done using, for example, white light, or emission may be detected using, for example, infrared light. These different wavelengths would result in better image by appropriate selection of the droplet size of the mist. This can be selected beforehand, or by the operator during testing.

On the other hand, in a further aspect of the invention, an improved imaging is obtained using a solid immersion lens (SIL) in combination with the objective lens. The SIL enables transmission of optical energy between the DUT and the objective lens practically regardless of the type and manner of cooling spray used. Thus, the atomizers and the fluid pressure can be selected for optimal heat removal efficiency.

Solid immersion lenses (SIL) are well known in the art and are described in, for example, USP 5,004,307, 5,208,648, and 5,282,088, which are incorporated herein by reference. Figure 4 depicts an embodiment of the cooling system of the invention used in conjunction with a SIL. As exemplified in Figure 4, many of the elements of this embodiment are similar to those of the embodiments of Figures 2 and 3; however, in this embodiment, a SIL 450 is affixed to the tip of the objective housing 405 and four atomizer banks 415 are used with two flow inducing injectors 462. Notably, the use of four atomizer banks and two injectors here is divorced from the use of a SIL, but it is rather shown here so as to illustrate two alternatives in a single drawings. That is, the SIL can be used with only two or other number of atomizer banks, and the embodiments lacking a SIL can be constructed using four or other number of atomizer banks and injectors.

In operation, the SIL 450 is "coupled" to the DUT, so as to allow communication of evanescent wave energy. In other words, the SIL is coupled to the DUT so that it captures rays propagating in the DUT at angles higher than the critical angle (the critical angle is that at which total internal reflection occurs). As is known in the art, the coupling can be achieved by, for example, physical contact with the imaged object, very close placement (up to about 20-200 micrometers) from the object, or the use of index matching material or fluid. In addition to increasing the efficiency of light collection, the use of SIL 450 also prevents, or dramatically reduces, any deleterious effects of the mist on the image because the mist cannot intervene between the SIL and the DUT.

In the embodiment of Figure 2, two banks of atomizers and one injector are used. On the other hand, in the embodiment of Figure 4, four banks of atomizers and two injectors are shown as an illustration of an alternative embodiment. It should be appreciated, however, that the number of atomizers and the number of banks of atomizers are provided only as examples, and other numbers and arrangements may be used. For example, the atomizers may be placed in a circular arrangement about the objective housing, rather than in linear banks. Similarly, the atomizers may be attached directly to any optical receiver used, e.g., objective lens housing, rather than placed in a spray head. Furthermore, various injectors may be operated at different spray rates or be provided with different cooling fluid, or same cooling fluid, but at different temperature. Optionally, different spray heads may be adjusted to provide spray at different angles. Regardless of the atomizer arrangement used, the flow inducing injector should be placed so as to direct its flow at a location of potential stagnation in the flow of the coolant from the atomizers. When a SIL is used, it is beneficial to direct the flow in a direction starting from the SIL contact location and away towards the edge of the cooling chamber.

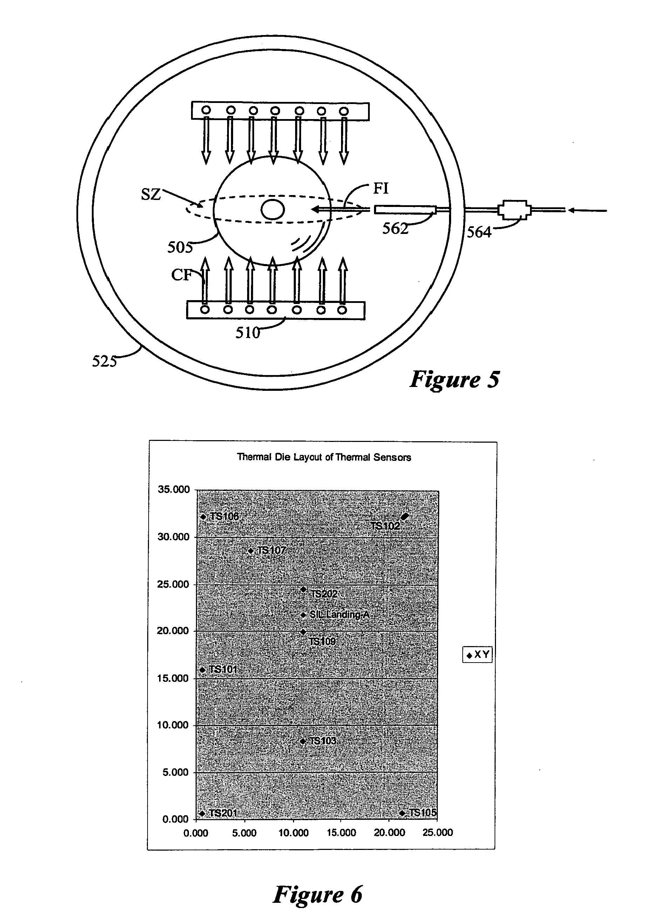

Figure 5 is a top view of an embodiment of the invention, such as that shown in Figure 2. As shown, the objective housing 505, the atomizer banks 510 and the flow inducing injector 562 are within the chamber 525. The atomizer banks create a coolant flow illustrated by arrows CF. The inventor has determined that the coolant flow creates stagnation zones, such as that illustrated by the broken-line oval SZ. Such stagnation zone can lead to inadequate cooling of the DUT, leading to undesirable temperature gradient in the DUT. To avoid such a problem, the inventor has devised a flow inducing injector 562, that injects coolant or other fluid into the stagnation zone, as illustrated by double-arrow FI, to induce flow. By properly directing the flow and controlling the rate of fluid delivery to the injector, the temperature gradient can be drastically reduced or even eliminated. The flow can be controlled by, e.g., controlling the pressure of the fluid having a pressure sensor 564 measuring the pressure of the fluid delivered to the injector. Alternatively, the temperature of the fluid can also be controlled and/or conditioned in the same manner as shown with respect to the coolant fluid. As can be understood, this arrangement can be used with or without a SIL.

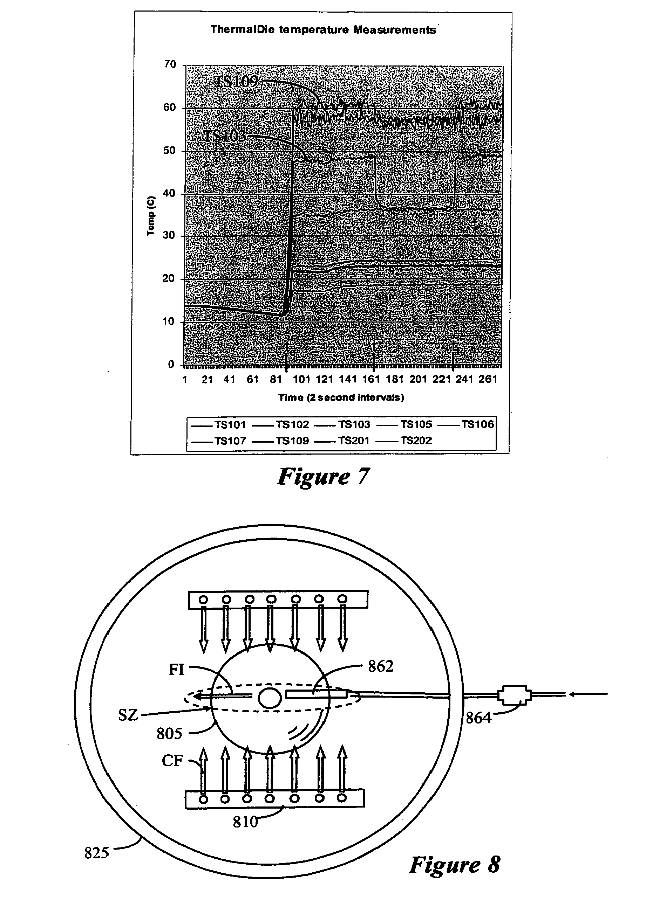

Figure 6 depicts a DUT having various point of temperature measurement, TS101- TS107, TS109, TS201 and TS202. Also, the location of the SIL on the DUT is also noted. As is shown in figure 7, the DUT has been energized at time about tₑ = 86, with the atomizer banks injecting coolant onto the DUT. Various locations on the DUT register different temperatures, as shown by the various plots. Notably, a relatively high temperature reading is registered by sensors TS103, TS109, and TS202. These sensors align along the mid-point line between the two atomizer banks, and the relatively high temperature is believed to be resulting from stagnation area between the flows emanating from the two atomizer banks. At time tᵢ, the flow inducing injector has been activated. As can be seen, the temperature registered by sensor TS103 drops almost 15 degrees. The temperature registered by sensor TS109 also drops, albeit not as much. An even lower drop, but nevertheless a recordable drop, has been registered by sensor TS202. This demonstrates that by constructing a flow inducing injector, control of the temperature at the stagnation point can be improved. On the other hand, when the flow inducing injector has been turned off, at time t_{f}, the temperature at the stagnation zone rises right back to the same temperature as before the activation of the injector. Thus, it is shown that the flow inducing injector help in reducing temperature gradient on the DUT. Notably, what is shown is a single test at a single pressure and flow setting. It should be understood that by proper design and setting, an improved result can be achieved.

Figure 8 depicts an embodiment that is similar to that of Figure 5, except that the flow direction is directed from the SIL contact area and outwards. That is, the elements shown in Figure 8 are similar to that of Figure 5. However, the injector 862 is situated so that the flow inducing jet, FI, starts at the contact location of the SIL and is directed outwards therefrom. As can be understood, more than one injectors 862 may be provided, depending on the flow stagnation zones.
According to some embodiments described herein, a micro-spray cooling system beneficial for use in testers of electrically stimulated integrated circuit chips can be provided. The system can include micro-spray heads disposed about a probe head, which provide a coolant flow onto the IC. A flow inducing injector is provided that directs a fluid jet onto zones where stagnation of the coolant flow is present. This reduces or eliminates any stagnation points and enhance temperature uniformity over the area of the IC.

While the invention has been described with reference to particular embodiments thereof, it is not limited to those embodiments. Specifically, various variations and modifications may be implemented by those of ordinary skill in the art without departing from the invention's spirit and scope, as defined by the appended claims. For example, the term atomizer used in this specification refers to an apparatus which provides a micro-spray, fine spray, a fine mist, etc. This can be achieved in a conventional manner, such as using nozzles. Additionally, any cited prior art references are incorporated herein by reference.

## Claims

1. A method for controlling operating temperature of an IC undergoing testing, comprising:
a. injecting fluid onto said IC (160; 360) using a plurality of atomizers (215; 415);
b. determining stagnation areas of flow of said fluid; and
c. directing at least one flow inducing fluid jet from at least one injector (190; 362; 462; 562; 862) onto said stagnation area.

2. The method of claim 1, further comprising measuring the temperature of said IC and controlling the flow of said injector according to the measured temperature.

3. The method of any of claims 1 to 2, wherein said injector comprises a plurality of flow inducing injectors (190; 362; 462; 562; 862).

4. The method of any of claims 1 to 3, further comprising collecting fluid sprayed onto the IC, and delivering collected fluid to the temperature conditioning system.

5. An apparatus for controlling the temperature of an IC (160; 360) undergoing testing, comprising:
a cooling head comprising a bank of atomizers (215; 415) providing a flow of fluid onto said IC;
a flow inducing injector (190; 362; 462; 562; 862) providing a fluid jet directed at a location of flow stagnation generated by said flow of fluid, to thereby reduce said flow stagnation.

6. The apparatus of claim 5, further comprising a piping system for circulating said fluid.

7. The apparatus of claim 6, wherein the piping is structured to further collect said fluid jet for recirculation.

8. The apparatus of any of claims 5 to 7, further comprising a cooling chamber housing said coolant head and said flow inducing injector.

9. The apparatus of any of claims 5 to 8, further comprising an objective housing (205; 405; 505) situated in said cooling chamber and housing an objective lens therein.

10. The apparatus of claim 9, further comprising a solid immersion lens (SIL) coupled to said objective housing.

11. The apparatus of any of claims 5 to 10, wherein the testing comprises sensing optical emissions from the IC.

12. The apparatus of any of claims 5 to 11, further comprising a pressure sensor (322) measuring the pressure of said fluid.

13. The apparatus of any of claims 5 to 12, further comprising a pressure sensor (320; 240; 564) measuring the pressure of fluid delivered to said injector.

14. The apparatus of any of claims 5 to 13, further comprising a temperature sensor (241; 340) measuring the temperature of fluid delivered to said injector.

15. A method for testing of an IC, the method comprising:
a. providing a test signal to the IC (160; 360);
b. spraying at least a portion of the IC with the cooling fluid;
c. directing a flow inducing fluid jet at flow stagnation areas of said cooling fluid; and
d. sensing output response from the IC.

16. The method of claim 15, further comprising conditioning the temperature of the cooling fluid before the spraying.

17. The method of any of claims 15 to 16, further comprising conditioning the temperature of the fluid jet.

18. The method of any of claims 15 to 17, further comprising controlling the pressure of the fluid jet.

19. The method of any of claims 15 to 18, wherein said sensing output response comprises sensing optical output from said IC.

20. The method of any of claims 15 to 19, wherein the fluid jet comprises coolant fluid.
